# FASCICULE DE BREVET EUROPEEN

(11) **EP 1 638 149 B1**
(45) Date de publication et mention de la délivrance du brevet: **23.11.2011**
(21) Numéro de dépôt: 05291905.7
(22) Date de dépôt: 14.09.2005
(51) Int. Cl.: H01L 29/78, H01L 21/336, H01L 29/786

(54) **Procédé de fabrication d'un transistor à effet de champ à grille isolée à canal à hétérostructure**
Verfahren zur Herstellung eines Feldefekttransistors mit isoliertem Gatter und Heterostruktur-Kanal
Method of manufacture of an heterostructure channel insulated gate field effect transistor

(30) Priorité: 15.09.2004 FR 0409749
(43) Date de publication de la demande: 22.03.2006
(73) Titulaire: STMicroelectronics (Crolles 2) SAS, 38920 Crolles (FR); Commissariat à l'Énergie Atomique et aux Énergies Alternatives, 75015 Paris (FR)
(72) Inventeur: Monfray, Stéphane, 38000 Grenoble (FR); Borel, Stéphan, 38400 Saint-Martin d'Heres (FR); Skotnicki, Thomas, 38920 Crolles (FR)
(74) Mandataire: Zapalowicz, Francis

(56) Documents cités:
- WO-A-03/105204
- FR-A- 2 838 237
- US-A1- 2002 089 003
- TEZUKA T ET AL: "Novel fully-depleted SiGe-on-insulator pMOSFETs with high-mobility SiGe surface channels" INTERNATIONAL ELECTRON DEVICES MEETING 2001. IEDM. TECHNICAL DIGEST. WASHINGTON, DC, DEC. 2 - 5, 2001, NEW YORK, NY : IEEE, US, 2 décembre 2001 (2001-12-02), pages 3361-3363, XP010575278 ISBN: 0-7803-7050-3
- LEE B H ET AL: "Performance enhancement on sub-70 nm strained silicon SOI MOSFETs on ultra-thin thermally mixed strained silicon/SiGe on insulator (TM-SGOI) substrate with raised S/D" INTERNATIONAL ELECTRON DEVICES MEETING 2002. IEDM. TECHNICAL DIGEST. SAN FRANCISCO, CA, DEC. 8 - 11, 2002, NEW YORK, NY : IEEE, US, 8 décembre 2002 (2002-12-08), pages 946-948, XP010626195 ISBN: 0-7803-7462-2
- SKOTNICKI T: "SILICON ON NOTHING (SON) - FABRICATION, MATERIAL AND DEVICES" ELECTROCHEMICAL SOCIETY PROCEEDINGS, ELECTROCHEMICAL SOCIETY, PENNINGTON, NJ, US, vol. 2001, no. 3, 25 mars 2001 (2001-03-25), pages 391-402, XP008014133 ISSN: 0161-6374
- YEE-CHIA YEO ET AL: "Enhanced performance in sub-100 nm CMOSFETs using strained epitaxial silicon-germanium" ELECTRON DEVICES MEETING, 2000. IEDM TECHNICAL DIGEST. INTERNATIONAL DECEMBER 10-13, 2000, PISCATAWAY, NJ, USA,IEEE, 10 décembre 2000 (2000-12-10), pages 753-756, XP010531871 ISBN: 0-7803-6438-4

## Description

La présente invention concerne les circuits intégrés, plus particulièrement l'élaboration de transistors à canaux à hétérostructure au sein de circuits intégrés.

Des transistors à canal semi-conducteur à hétérostructure Si/SiGe réalisés directement dans un substrat (« BULK ») sont connus.

De tels transistors ont cependant l'inconvénient de présenter des effets à canaux courts (SCE, « Short Canal Effect » en langue anglaise) et « d'abaissement de la barrière de potentiel induite par la polarisation du drain » (Drain Induced Barrier Lowering (DIBL) en langue anglaise). Plus précisément lorsque la longueur de la grille du transistor diminue, le potentiel au centre du canal va être fortement modifié et donc la tension de seuil du transistor va être changée, car la barrière de potentiel entre la source et le drain est abaissée. Cet effet est l'effet SCE. A cela se rajoute l'action du potentiel de drain qui va encore baisser la barrière de potentiel : c'est l'effet DIBL.

Le document "Novel fully-depleted SiGe-on-insulator pMOSFETs with high-mobility SiGe surface channels" (TEZUKA) concerne des transistors MOSFETs comprenant un canal de SiGe ultra-fin contraint pris en sandwich entre l'oxyde de grille et des couches d'oxyde enterrées.

La demande de brevet WO03/105204 concerne une structure semidconductrice comprenant une couche de substrat contrainte présentant une concentration en germanium d'au moins 10% atomique. La structure semiconductrice comprend aussi une couche comprimée sur la couche de substrat contrainte. La couche comprimée présente une concentration en germanium supérieure d'au moins 30% à la valeur de la concentration en germanium de la couche de substrat contrainte, et présente une épaisseur inférieure à son épaisseur critique. La structure semiconductrice comprend également une couche en tension sur la couche comprimée. La couche en tension peut être formée à partir de silicium présentant une épaisseur inférieure à son épaisseur critique. La demande concerne également un procédé de fabrication d'une structure semi-conductrice dans lequel: on forme un substrat; on forme une couche semiconductrice comprimée sur le substrat ; on dépose une couche semiconductrice en tension adjacente au substrat jusqu'à ce qu'une épaisseur d'une première région d'un semiconducteur en tension soit plus grande que l'épaisseur d'une seconde région d'un semiconducteur en tension ; on forme un dispositif à canal dopé n sur la première région et on forme un dispositif à canal dopé p sur la seconde région.

La demande de brevet FR 2 838 237 concerne un procédé de fabrication d'un transistor à effet de champ à grille isolée, comprenant : la formation sur un substrat de silicium d'une couche de base formée d'un alliage relaxé de silicium-germanium ; la formation sur une partie de la surface supérieure de la couche de base d'une première couche de silicium contraint, surmontée d'une couche intermédiaire de silicium-germanium, surmontée d'une deuxième couche de silicium contraint ; la formation sur ladite deuxième couche de la grille isolée du transistor flanquée de régions isolantes (espaceurs) ; une gravure de ladite couche intermédiaire de façon à former un tunnel sous la grille isolée flanquée de ses régions isolantes ; et le remplissage du tunnel par un matériau isolant, puis la formation des régions de source et de drain.

L'invention vise à apporter une solution à ce problème.

L'invention a pour but de proposer un transistor offrant une meilleure mobilité des porteurs dans le canal, tout en s'affranchissant des problèmes d'effets à canaux courts (SCE) et de DIBL, malgré une conduction enterrée des porteurs.

Un autre but de la présente invention est d'obtenir une augmentation de la conduction des électrons à travers une couche de silicium contraint en tension dans des dispositifs de type NMOS.

Un autre but de la présente invention est d'obtenir une augmentation de la conduction des trous à travers des couches de silicium contraint et de silicium-germanium comprimé dans des dispositifs de type PMOS.

La présente invention propose donc un procédé de fabrication d'un transistor à effet de champ à grille isolée comprenant :
a- le dépôt, sur une zone active d'un substrat, d'une couche constituée d'un matériau sélectivement éliminable par rapport au matériau constituant la zone active,
b- la réalisation d'un canal fin semi-conducteur contraint à hétérostructure sur la couche de matériau sélectivement éliminable,
c- la réalisation d'une grille isolée sur le canal,
d- le retrait sélectif de la couche de matériau sélectivement éliminable de façon à créer une cavité sous le canal,
e- le dépôt d'un matériau diélectrique dans ladite cavité de façon à créer un bloc diélectrique,
f- la réalisation à partir de la zone active du substrat d'une région de source et d'une région de drain s'étendant d'une part et d'autre et au contact du canal, le bloc diélectrique étant alors enterré sous le canal.

En combinant un canal fin semi-conducteur contraint à hétérostructure avec un diélectrique enterré sous ledit canal et délimitant ce dernier, on obtient une meilleure mobilité des porteurs dans le canal, tout en s'affranchissant des problèmes des transistors de l'art antérieur, i.e. effets à canaux courts et de DIBL.

L'homme du métier saura choisir l'épaisseur du canal pour obtenir un canal fin. Cela étant, à titre indicatif, l'épaisseur d'un tel canal est avantageusement inférieure à 10 nm.

Selon un mode de mise en oeuvre de l'invention, la zone active du substrat comprend un alliage silicium-germanium dont le rapport de la concentration en germanium sur la concentration en silicium augmente en direction de la surface du substrat, et la couche constituée d'un matériau sélectivement éliminable est une couche de silicium contraint obtenue par épitaxie à partir de la surface supérieure de la zone active du substrat.

On peut par exemple former le canal en épitaxiant une première couche d'alliage de silicium-germanium sur la couche de silicium contraint afin d'obtenir une couche d'alliage de silicium-germanium comprimé, et en épitaxiant une seconde couche de silicium sur ladite première couche, de façon à obtenir du silicium contraint en tension.

Selon un mode de mise en oeuvre de l'invention, la formation des régions de source et de drain comprend une épitaxie d'un matériau comprenant du silicium.

D'autres avantages et caractéristiques de l'invention apparaîtront à l'examen de la description détaillée de modes de réalisation et de mise en oeuvre, nullement limitatifs, et des dessins annexés, sur lesquels :
- les figures 1 à 7 illustrent schématiquement les principales étapes d'un mode de mise en oeuvre d'un procédé selon la présente invention, et
- la figure 8 représente schématiquement un transistor à effet de champ à grille isolée au sein d'un circuit intégré.

On va maintenant décrire plus en détails, les principales étapes d'un mode de mise en oeuvre du procédé selon l'invention.

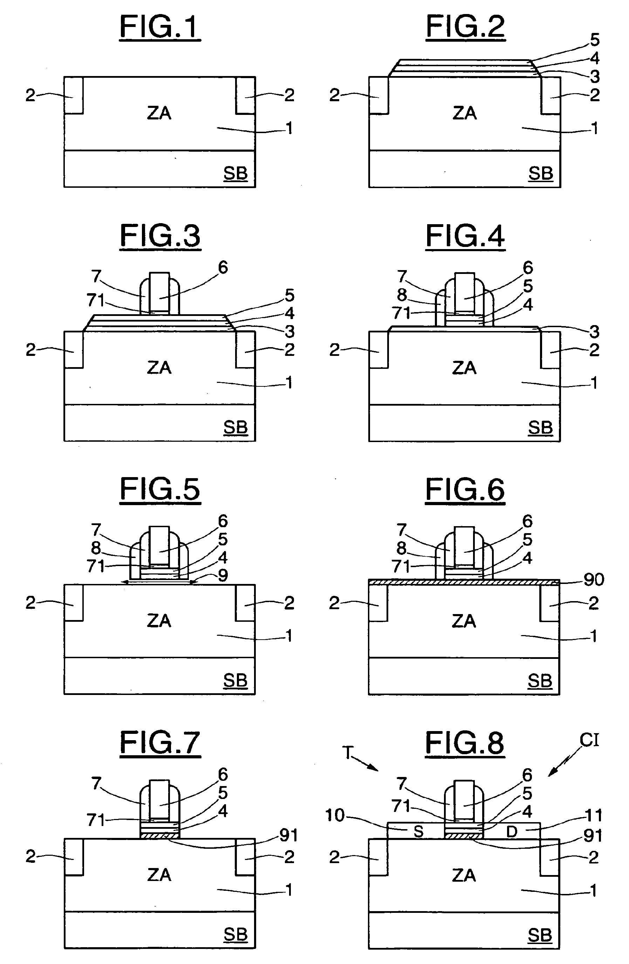

Sur la figure 1, on forme par épitaxie sur un substrat SB, par exemple en silicium, une couche 1 d'un alliage silicium-germanium dont le rapport de la concentration en germanium sur la concentration en silicium augmente en direction de la surface du substrat SB. Le silicium et le germanium constituant l'alliage est présent en un rapport Si₁₋ₓGeₓ, avec x variant par exemple de 0 à 0,2 en direction de la surface du substrat (SB).

Dans cette couche 1, une zone active ZA est formée entre deux zones d'isolation 2, lesdites zones d'isolation pouvant être des tranchées d'isolation. Ces tranchées d'isolation peuvent être, par exemple, profondes de type DTI (« Deep Trench Isolation ») ou peu profondes de type STI (« Shallow Trench Isolation »).

Sur la zone active ZA (figure 2), on forme une couche 3 de silicium par épitaxie sélective, ledit silicium étant contraint en raison de la non-continuité des mailles entre le réseau cristallin du silicium de la couche 3 et celui de l'alliage SiGe de la zone active ZA. A titre indicatif, l'épaisseur de la couche 3 peut être de 15 nm, mais est plus généralement comprise entre 10 nm et 40 nm.

De la même façon, on réalise par épitaxie sélective, une couche 4 d'un alliage de silicium-germanium contraint et comprimé sur la couche 3. A cet égard le pourcentage de germanium dans la couche 4 est choisi supérieur au pourcentage de germanium dans la zone active ZA. L'épaisseur de la couche 4 peut par exemple être de 3 nm, mais est plus généralement comprise entre 1 nm et 5 nm.

Une couche 5 de silicium contraint et en tension est ensuite réalisée par épitaxie sélective sur la couche 4. L'épaisseur de la couche 5 peut par exemple être de 3 nm, mais est plus généralement comprise entre 1 nm et 5 nm.

On réalise ensuite une région de grille 6, pouvant être en polysilicium, par des moyens connus en soi. Cette région de grille 6 est entourée d'espaceurs 7 (figure 3) et est séparée de la couche 5 de silicium en tension par une couche d'oxyde de silicium 71 (oxyde de grille).

Sur la figure 4, les couches 4 et 5, respectivement d'alliage de silicium-germanium comprimé et de silicium contraint, sont gravées par des moyens connus, par exemple par gravure anisotropique, en utilisant la région de grille 6 et les espaceurs 7 en tant que masques. Des espaceurs supplémentaires 8 sont réalisés de part et d'autre des espaceurs 7 et des couches 4 et 5, lesdits espaceurs serviront ultérieurement de masques.

La couche 3 de silicium contraint est ensuite éliminée (figure 5), laissant ainsi place à une cavité 9 entre la couche 4 d'alliage SiGe comprimé et la surface de la zone active ZA. Cette élimination est effectuée par des moyens connus, par exemple par gravure plasma isotrope sélective en utilisant un plasma du type (CF₄, CH₂F₂, N₂, O₂). Les conditions de pression et de température seront ajustées par l'homme du métier pour obtenir une vitesse de gravure désirée. La gravure peut par exemple s'effectuer à 25°C et à pression atmosphérique.

On effectue ensuite un dépôt d'une couche 90 d'un diélectrique (par exemple du SiO₂) sur la surface de la zone active ZA et dans la cavité 9 (figure 6).

Sur la figure 7, ladite couche 90 de diélectrique est gravée, par des moyens connus, par exemple par gravure anisotropique, en utilisant les espaceurs 8 comme masques.

On forme (figure 8), par épitaxie sélective, des zones semiconductrices 10 et 11, de part et d'autre du transistor, à partir de la zone active ZA jusqu'au niveau de la surface de la couche 5 de silicium contraint en tension. Puis on effectue une implantation de dopant sur ces zones 10 et 11 pour former les régions de source et de drain.

Le bloc diélectrique 91, maintenant enterré dans le substrat, a une épaisseur identique à la couche 3 de silicium contraint de départ, c'est-à-dire typiquement 15 nm, plus généralement compris par exemple entre 10 nm et 40 nm.

Sur la figure 8, on a donc représenté un circuit intégré CI comprenant un transistor T à effet de champ à grille isolée .

Le circuit intégré comporte un substrat SB, surmonté d'une couche 1 d'alliage de silicium-germanium dont le rapport de la concentration en germanium sur la concentration en silicium augmente en direction de la surface du substrat (SB).

Le transistor T est réalisé sur la zone active ZA dans ladite couche 1 et se trouve entre deux zones d'isolation 2. Ledit transistor comprend un canal fin semi-conducteur contraint à hétérostructure, constitué d'une couche 4 d'alliage en SiGe comprimé et d'une couche 5 de silicium en tension, s'étendant entre la grille 6 et un bloc diélectrique 91 enterré dans le substrat SB.

## Revendications

1. Procédé de fabrication d'un transistor à effet de champ à grille isolée (T) comprenant :
a. le dépôt, sur une zone active (ZA) d'un substrat (SB), d'une couche (3) constituée d'un matériau sélectivement éliminable par rapport au matériau constituant la zone active (ZA),
b. la réalisation d'un canal fin semi-conducteur contraint à hétérostructure (4,5) sur la couche de matériau sélectivement éliminable (3),
c. la réalisation d'une grille isolée (6) sur le canal (4,5),
d. le retrait sélectif de la couche de matériau sélectivement éliminable (3) de façon à créer une cavité (9) sous le canal (4,5),
e. le dépôt d'un matériau diélectrique (91) dans ladite cavité (9) de façon à créer un bloc diélectrique,
f. la réalisation à partir de la zone active (ZA) du substrat (SB) d'une région de source (10) et d'une région de drain (11) s'étendant d'une part et d'autre et au contact du canal (4,5), le bloc diélectrique (91) étant alors enterré sous le canal (4,5).

2. Procédé selon la revendication 1, **caractérisé en ce que** l'épaisseur de canal (4,5) est inférieure à 10 nm.

3. Procédé selon la revendication 1 ou 2, **caractérisé en ce que** la zone active du substrat (ZA) comprend un alliage de silicium-germanium dont le rapport de la concentration en germanium sur la concentration en silicium augmente en direction de la surface du substrat (SB) et **en ce que** la couche (3) constituée d'un matériau sélectivement éliminable est une couche de silicium contraint obtenue par épitaxie à partir de la surface supérieure de la zone active (ZA) du substrat (SB).

4. Procédé selon la revendication 3, dans lequel on forme le canal (4,5) en épitaxiant une première couche d'alliage de silicium-germanium, sur la couche de silicium contraint (3) afin d'obtenir une couche d'alliage de silicium-germanium comprimé (4), et en épitaxiant une seconde couche de silicium (5) sur ladite première couche afin d'obtenir une couche de silicium contraint en tension, et dans lequel on entoure la grille isolée (6) avec des espaceurs (7), on grave le canal (4, 5) en utilisant la région de grille et les espaceurs (7) en tant que masques, on réalise des espaceurs supplémentaires (8) de part et d'autre des espaceurs (7) et du canal (4, 5) et on retire la couche de matériau sélectivement éliminable (3) de façon à créer une cavité (9) sous le canal (4,5).

5. Procédé selon l'une quelconque des revendications 1 à 4, dans lequel la formation des régions de source (10) et de drain (11) comprend une épitaxie d'un matériau comprenant du silicium.

## Claims

1. Process for fabricating an insulated-gate field-effect transistor (T), comprising:
a) the deposition, on an active zone (AZ) of a substrate (SB), of a layer (3) made of a material that can be removed selectively with respect to the material constituting the active zone (AZ);
b) the formation of a narrow heterostructure strained-semiconductor channel (4, 5) on the layer of selectively removable material (3),
c) the formation of an insulated gate (6) on the channel (4, 5);
d) the selective removal of the layer (3) of selectively removable material so as to create a cavity (9) under the channel (4, 5);
e) the deposition of a dielectric material (91) in the said cavity (9) so as to create a dielectric block; and
f) the formation, from the active zone (AZ) of the substrate (SB), of a source region (10) and a drain region (11) extending on either side and in contact with the channel (4, 5), the dielectric block (91) then being buried beneath the channel (4, 5).

2. Process according to Claim 1, **characterized in that** the thickness of the channel (4, 5) is less than 10 nm.

3. Process according to Claim 1 or 2, **characterized in that** the active zone (AZ) of the substrate comprises a silicon-germanium alloy, the ratio of the germanium concentration to the silicon concentration of which increases towards the surface of the substrate (SB) and **in that** the layer (3) made of a selectively removable material is a strained silicon layer obtained by epitaxy from the upper surface of the active zone (AZ) of the substrate (SB).

4. Process according to Claim 3, in which the channel (4, 5) is formed by epitaxially growing a first layer of silicon-germanium alloy on the strained silicon layer (3) so as to obtain a layer (4) of silicon-germanium alloy in compression and by epitaxially growing a second layer (5) of silicon on the said first layer so as to obtain a layer of strained silicon in tension, and in which the insulated gate (6) is surrounded by spacers (7), the channel (4, 5) is etched using the gate region and the spacers (7) as masks, additional spacers (8) are produced on either side of the spacers (7) and of the channel (4, 5) and the layer (3) of selectively removable material is removed so as to create a cavity (9) beneath the channel (4, 5).

5. Process according to any one of Claims 1 to 4, in which the source (10) and drain (11) regions are formed by epitaxial growth of a material comprising silicon.

## Patentansprüche

1. Verfahren zur Herstellung eines Feldeffekttransistors mit isoliertem Gate (T), das enthält:
a. das Aufbringen, auf eine aktive Zone (ZA) eines Substrats (SB), einer Schicht (3) bestehend aus einem bezüglich des die aktive Zone (ZA) bildenden Materials selektiv entfernbaren Material,
b. die Herstellung eines dünnen verspannten Halbleiterkanals mit Heterostruktur (4, 5) auf der Schicht aus selektiv entfernbarem Material (3),
c. die Herstellung eines isolierten Gates (6) auf dem Kanal (4, 5),
d. das selektive Entfernen der Schicht aus selektiv entfernbarem Material (3), um einen Hohlraum (9) unter dem Kanal (4, 5) zu erzeugen,
e. das Aufbringen eines dielektrischen Materials (91) in den Hohlraum (9), um einen dielektrischen Block zu erzeugen,
f. die Herstellung, ausgehend von der aktiven Zone (ZA) des Substrats (SB), eines Source-Bereichs (10) und eines Drain-Bereichs (11), die sich zu beiden Seiten und in Kontakt mit dem Kanal (4, 5) erstrecken, wobei der dielektrische Block (91) dann unter dem Kanal (4, 5) begraben ist.

2. Verfahren nach Anspruch 1, **dadurch gekennzeichnet, dass** die Kanaldicke (4, 5) geringer als 10 nm ist.

3. Verfahren nach Anspruch 1 oder 2, **dadurch gekennzeichnet, dass** die aktive Zone des Substrats (ZA) eine Silicium-Germanium-Legierung enthält, deren Verhältnis der Germaniumkonzentration zur Siliciumkonzentration in Richtung der Oberfläche des Substrats (SB) zunimmt, und dass die aus einem selektiv entfernbaren Material bestehende Schicht (3) eine verspannte Siliciumschicht ist, die durch Epitaxie ausgehend von der Oberfläche der aktiven Zone (ZA) des Substrats (SB) erhalten wird.

4. Verfahren nach Anspruch 3, bei dem der Kanal (4, 5) geformt wird, indem eine erste Schicht einer Silicium-Germanium-Legierung auf die verspannte Siliciumschicht (3) epitaxiert wird, um eine Schicht einer komprimierten Silicium-Germanium-Legierung (4) zu erhalten, und indem eine zweite Siliciumschicht (5) auf die erste Schicht epitaxiert wird, um eine zugverspannte Siliciumschicht zu erhalten, und bei dem das isolierte Gate (6) mit Abstandshaltern (7) umgeben wird, der Kanal (4, 5) eingraviert wird, indem der Gate-Bereich und die Abstandshalter (7) als Masken verwendet werden, zusätzliche Abstandshalter (8) zu beiden Seiten der Abstandshalter (7) und des Kanals (4, 5) hergestellt werden, und die Schicht aus selektiv entfernbarem Material (3) so entfernt wird, dass ein Hohlraum (9) unter dem Kanal (4, 5) erzeugt wird.

5. Verfahren nach einem der Ansprüche 1 bis 4, bei dem die Bildung der Source- (10) und Drain-Bereiche (11) eine Epitaxie eines Silicium enthaltenden Materials enthält.
